# EUROPÄISCHE PATENTSCHRIFT

(11) **EP 2 289 293 B1**
(45) Veröffentlichungstag und Bekanntmachung des Hinweises auf die Patenterteilung: **01.03.2017**
(21) Anmeldenummer: 09753618.9
(22) Anmeldetag: 13.05.2009
(51) Int. Cl.: H05K 7/20, F28D 15/02

(54) **KÜHLEN EINER ELEKTRONISCHEN EINRICHTUNG IN EINEM LUFTFAHRZEUG DURCH EINE FALLWEISE EINPHASIGE ODER ZWEIPHASIGE KÜHLUNG**
COOLING AN ELECTRONIC DEVICE IN AN AIRCRAFT BY CASE-BY-CASE SINGLE-PHASE OR TWO-PHASE COOLING
REFROIDISSEMENT D'UN DISPOSITIF ÉLECTRONIQUE D'UN AÉRONEF PAR UN REFROIDISSEMENT ÉVENTUELLEMENT MONOPHASIQUE OU BIPHASIQUE

(30) Priorität: 30.05.2008 DE 102008025951; 30.05.2008 US 57403
(43) Veröffentlichungstag der Anmeldung: 02.03.2011
(73) Patentinhaber: Airbus Operations GmbH, 21129 Hamburg (DE)
(72) Erfinder: REISS, Matthias, 22607 Hamburg (DE); CASAS NORIEGA, Wilson Willy, 21147 Hamburg (DE); ROERING, Sebastian, 20359 Hamburg (DE)
(74) Vertreter: Schicker, Silvia
(86) Internationale Anmeldenummer: PCT/EP2009/003412
(87) Internationale Veröffentlichungsnummer: WO 2009/143963

(56) Entgegenhaltungen:
- DE-U1-202004 003 644
- JP-A- 2001 010 595
- US-A- 4 057 104
- US-A1- 2002 075 652

## Beschreibung

Die Erfindung betrifft die Kühlung einer Elektronikeinrichtung in einem Luftfahrzeug mit einem Kühlmittel, das sich im Normalbetrieb im einphasigen, flüssigen Zustand befindet und in einem Fehlerfall sowohl den gasförmigen als auch den flüssigen Zustand aufweisen kann.

Bei einem Luftfahrzeug des Standes der Technik wird eine Elektronikeinrichtung mit Luft gekühlt. Falls sich das Luftfahrzeug am Boden befindet, wird zum Kühlen der Elektronikeinrichtung Luft aus der Kabine entnommen und in die Kabine zurückgeführt. Dazu sind Gebläse erforderlich, die eine erhebliche Geräuschbelastung verursachen. Ferner führt die in die Kabine geleitete Abwärme zu einer unerwünschten Erwärmung der Kabine.

Bei einer Kühleinrichtung des Standes der Technik zirkuliert während des Fluges Luft zwischen der Elektronikeinrichtung und einem Flugzeugaußenhautwärmetauscher. Da Luft nur relativ niedrige Wärmemengen aufnehmen kann, sind große Luftmengen, große Wärmetauscherflächen und Luftschächte mit einem großen Querschnitt erforderlich. Dadurch erhöht sich das Gewicht und der Raumbedarf der Kühleinrichtung sowie der Elektronikeinrichtung. Dies führt zu Problemen beim Einbau in ein Flugzeug. Sowohl zum Zuführen von Luft zur Elektronikeinrichtung als auch zum Abführen von Luft von der Elektronikeinrichtung ist je ein Gebläse erforderlich. Die Gebläse weisen einen vergleichsweise hohen Stromverbrauch auf, was zu einem erhöhten Kerosinverbrauch am Boden und während des Fluges führt. Ferner verursachen die Gebläse Vibrationen und Lärm. Bei einem Ausfall eines der Gebläse muss die Elektronikeinrichtung ausgeschaltet werden, da bei einer zu hohen Betriebstemperatur die Gefahr einer Fehlfunktion besteht. Da bei ausgeschalteter Elektronikeinrichtung bestimmte Funktionen nicht mehr vorhanden sind, kann die Sicherheit des Luftfahrzeuges beeinträchtigt werden.

Die JP 2001-010595 schlägt die Kühlung einer Elektronikeinrichtung mit Hilfe von drei kaskadierten Kühlkreisläufen vor. Im ersten Kühlkreislauf zirkuliert Kühlmittel durch einen Flugzeugaußenhautwärmetauscher und einen Kondensator eines zweiten Kühlkreislaufs. Der zweite Kühlkreislauf erzeugt Kälte durch Verdichten, Kondensieren und Verdampfen. Der Verdampfer des zweiten Kühlkreislaufs kühlt einen Wärmetauscher eines dritten Kühlkreislaufs, der die Elektronikeinrichtung kühlt. Alle drei Kühlkreisläufe weisen eine Zwangskonvektion durch je eine Pumpeinrichtung auf. Bei einem Ausfall einer der drei Pumpeinrichtungen, die die Zwangskonvektion sicherstellen, kann die Elektronikeinrichtung nicht mehr betrieben werden und die Sicherheit des Luftfahrzeuges wird beeinträchtigt.

Es ist eine Aufgabe der Erfindung, eine zuverlässigere Kühlung einer Elektronikeinrichtung in einem Luftfahrzeug bereitzustellen.

Bei einem erfindungsgemäßen Verfahren zum Kühlen einer Elektronikeinrichtung in einem Luftfahrzeug zirkuliert Kühlmittel in einem Kühlmittelkreislauf. Die Elektronikeinrichtung wird mit dem Kühlmittel gekühlt, und die vom Kühlmittel aufgenommene Wärme wird in einem Luftfahrzeugaußenhautwärmetauscher an die Umgebung abgegeben. Das Kühlmittel kann beim Kühlen der Elektronikeinrichtung zumindest teilweise verdampfen und im Luftfahrzeugaußenhautwärmetauscher kondensieren. Das Kühlmittel zirkuliert aufgrund natürlicher Konvektion im Kühlmittelkreislauf. Die Erfindung hat den Vorteil, dass keine Pumpeinrichtung erforderlich ist, um die Zwangskonvektion sicherzustellen. Dies erhöht die Zuverlässigkeit und die Sicherheit des Luftfahrzeuges. Ferner wird die Masse des Luftfahrzeuges reduziert, was den Kerosinverbrauch reduziert. Ferner sind keine Kältemaschine, Ventilatoren und Luftschächte mit einem großen Querschnitt erforderlich. Dadurch wird die Masse und der Raumbedarf einer Kühleinrichtung für die Elektronikeinrichtung reduziert und die Integration in ein Luftfahrzeug vereinfacht.

Das Kühlmittel kann sich im Normalbetrieb ständig in flüssigem Zustand befinden und aufgrund einer Zwangskonvektion im Kühlmittelkreislauf zirkulieren. Im Fehlerfall verdampft das Kühlmittel beim Kühlen der Elektronikeinrichtung zumindest teilweise und kondensiert im Luftfahrzeugaußenhautwärmetauscher, wie zuvor beschrieben wurde. Im Fehlerfall zirkuliert das Kühlmittel im Kühlmittelkreislauf aufgrund natürlicher Konvektion. Der Fehlerfall kann beispielsweise der Ausfall einer Pumpeinrichtung zum Sicherstellen der Zwangskonvektion sein.

Der Fehlerfall kann auch eine verstärkte Nachfrage nach Kühlleistung sein. In diesem Fall kann auch zusätzlich eine Zwangskonvektion vorhanden sein.

Diese Ausführungsform hat den Vorteil, dass die Kühlleistung und somit die Temperatur der Elektronikeinrichtung durch Steuern der Zwangskonvektion gesteuert werden kann. Beispielsweise kann die Zwangskonvektion derart gesteuert werden, dass sich die die Elektronikeinrichtung umgebende Luft ständig bei einer Temperatur über dem Taupunkt und die Temperatur der Elektronikeinrichtung unterhalb einer Ausfalltemperatur befindet. Selbst bei einem Ausfall der Zwangskonvektion kann die Kühlung der Elektronikeinrichtung sichergestellt werden. Daher kann die Elektronikeinrichtung beim einem Ausfall der Zwangskonvektion weiter betrieben werden, wodurch die Sicherheit des Luftfahrzeuges erhöht wird.

Im Normalbetrieb befindet sich das Kühlmittel im einphasigen, flüssigen Zustand. Im Fehlerfall hat das Kühlmittel ein zweiphasiges Verhalten. Das Kühlmittel kann im Fehlerfall sowohl den flüssigen als auch gasförmigen Zustand einnehmen.

Das Kühlmittel kann zumindest teilweise am Luftfahrzeugaußenhautwärmetauscher vorbeigeleitet werden, falls die Temperatur im Luftfahrzeugaußenhautwärmetauscher einen ersten Schwellenwert überschreitet. Das Kühlmittel kann fallweise in einem Zusatzwärmetauscher gekühlt werden, der von einem weiteren Kühlsystem gekühlt wird. Dies kann erforderlich sein, falls sich das Luftfahrzeug am Boden befindet und/oder die Außentemperatur relativ hoch ist. In diesem Fall kann der Luftfahrzeugaußenhautwärmetauscher das Kühlmittel nicht kühlen. Das weitere Kühlsystem kann ein Flüssigkeitskühlsystem sein oder ein Kühlsystem sein, das durch Verdichten, Kondensieren und Verdampfen kühlt. Der erste Schwellenwert kann derart ausgewählt werden, dass das Kühlmittel beim Eintritt in die Elektronikeinrichtung eine Temperatur aufweist, mit der sichergestellt werden kann, dass sich die Temperatur der Elektronikeinrichtung sicher unterhalb der Ausfalltemperatur befindet. Der erste Schwellenwert kann auch der Ist-Temperatur des aus dem Kühlwärmetauscher austretendem Kühlmittels entsprechen. Ist die Temperatur des Luftfahrzeugaußenhautwärmetauscher niedriger als die Ist-Temperatur des aus dem Kühlwärmetauscher austretendem Kühlmittels strömt das Kühlmittel durch den Luftfahrzeugaußenhautwärmetauscher und wird zumindest teilweise gekühlt. Ist die Temperatur des Luftfahrzeugaußenhautwärmetauscher höher als die Ist-Temperatur des aus dem Kühlwärmetauscher austretendem Kühlmittels strömt das Kühlmittel nicht durch den Luftfahrzeugaußenhautwärmetauscher und kann somit nicht im Luftfahrzeugaußenhautwärmetauscher erwärmt werden.

Das Kühlmittel kann zumindest teilweise am Luftfahrzeugaußenhautwärmetauscher vorbeigeleitet werden, falls die Temperatur im Luftfahrzeugaußenhautwärmetauscher und/oder des Kühlmittels je einen entsprechenden zweiten Schwellenwert unterschreitet. Befindet sich das Luftfahrzeug in großer Höhe, kann die Außentemperatur sehr niedrige Werte annehmen. Indem das Kühlmittel zumindest teilweise am Luftfahrzeugaußenhautwärmetauscher vorbeigeleitet wird, kann sichergestellt werden, dass sich die Temperatur der die Elektronikeinrichtung umgebende Luft immer oberhalb des Taupunktes befindet. Dadurch wird eine Kondensation von Wasser in und/oder an der Elektronikeinrichtung verhindert, was die Zuverlässigkeit und Lebensdauer der Elektronikeinrichtung erhöht. Der zweite Schwellenwert kann folglich so ausgewählt werden, dass sich die Temperatur der die Elektronikeinrichtung umgebenden Luft immer oberhalb des Taupunktes befindet.

Die Erfindung betrifft auch eine Luftfahrzeugkühleinrichtung mit einem Kühlwärmetauscher, der dazu ausgebildet ist, mit einem Kühlmittel eine Elektronikeinrichtung zu kühlen, und einem Luftfahrzeugaußenhautwärmetauscher, der dazu ausgebildet ist, das Kühlmittel zu kühlen, wobei sich der Kühlwärmetauscher und der Luftfahrzeugaußenhautwärmetauscher in einem geschlossenen Kühlmittelkreislauf befinden. Das Kühlmittel kann beim Kühlen der Elektronikeinrichtung im Kühlwärmetauscher zumindest teilweise verdampfen und im Luftfahrzeugaußenhautwärmetauscher kondensieren. Das Kühlmittel zirkuliert aufgrund natürlicher Konvektion im Kühlmittelkreislauf. Als Kühlmittel kann beispielsweise das von Solvay Solexis vertriebene Kühlmittel Galden verwendet werden, das ein perfluorierter Polyether ist. Ferner können als Kühlmittel Propylenglykollösungen verwendet werden, die auch mit der Abkürzung PGW bezeichnet werden. Diese Kühleinrichtung arbeitet mit natürlicher Konvektion und erfordert folglich keine Pumpeinrichtung, was zu einer kompakten und ausfallsicheren Luftfahrzeugkühleinrichtung führt. Zum Sicherstellen der natürlichen Konvektion kann die Leitung zwischen dem Kühlwärmetauscher und dem Luftfahrzeugaußenhautwärmetauscher mit einem größeren Durchmesser bemessen sein. Das Kühlmittel fungiert als zweiphasiges Kühlmittel, da es sich sowohl im gasförmigen als auch im flüssigen Zustand befinden kann.

Die Luftfahrzeugkühleinrichtung kann eine Pumpeinrichtung aufweisen, die im Normalbetrieb Kühlmittel im Kühlmittelkreislauf zirkuliert. Die Luftfahrzeugkühleinrichtung kann so ausgebildet sein, dass sich im Normalbetrieb das flüssige Kühlmittel ständig in flüssigem Zustand befindet und aufgrund einer Zwangskonvektion durch die Pumpe im Kühlmittelkreislauf zirkuliert. Im Fehlerfall verdampft das Kühlmittel beim Kühlen der Elektronikeinrichtung zumindest teilweise im Kühlwärmetauscher und kondensiert im Luftfahrzeugaußenhautwärmetauscher. Im Fehlerfall zirkuliert das Kühlmittel aufgrund natürlicher Konvektion im Kühlmittelkreislauf. Wie zuvor erwähnt wurde, kann bei dieser Ausführungsform besonders einfach sichergestellt werden, dass sich die Temperatur der die Elektronikeinrichtung umgebenden Luft ständig oberhalb des Taupunktes befindet, wodurch die Zuverlässigkeit und Lebensdauer der Elektronikeinrichtung und somit die Sicherheit und Zuverlässigkeit des Luftfahrzeuges erhöht wird.

Die Luftfahrzeugkühleinrichtung kann ferner ein Luftfahrzeugaußenhautwärmetauscher-Bypassventil aufweisen, das dazu ausgebildet ist, das Kühlmittel am Luftfahrzeugaußenhautwärmetauscher zumindest teilweise vorbeizuleiten, falls die Temperatur im Luftfahrzeugaußenhautwärmetauscher einen ersten Schwellenwert überschreitet. Die Luftfahrzeugkühleinrichtung kann einen Zusatzwärmetauscher aufweisen, der fallweise von einem Zusatzkühlsystem gekühlt wird, wobei der Zusatzwärmetauscher so ausgebildet ist, dass das Kühlmittel des Kühlmittelkreislaufs im Zusatzwärmetauscher gekühlt wird, falls der Zusatzwärmetauscher vom Zusatzkühlsystem gekühlt wird. Wie zuvor erwähnt, kann die Außentemperatur beispielsweise hohe Werte aufweisen, falls sich das Luftfahrzeug am Boden befindet. In diesem Fall kann der Luftfahrzeugaußenhautwärmetauscher das Kühlmittel unter Umständen nicht mehr so stark kühlen, dass sich die Temperatur der Elektronikeinrichtung immer unter der Ausfalltemperatur befindet. Das Kühlmittel wird in diesem Fall teilweise oder vollständig von einem Zusatzwärmetauscher gekühlt, der von dem Zusatzkühlsystem gekühlt wird. Das Zusatzkühlsystem kann ein Flüssigkeitskühlsystem, beispielsweise ein sogenannter Kältebus, sein oder einen Zyklus aus Verdichtung, Kondensation und Verdampfung aufweisen. Der erste Schwellenwert kann so gewählt werden, dass sichergestellt wird, dass das Kühlmittel beim Eintritt in den Kühlwärmetauscher eine Temperatur aufweist, mit der sichergestellt werden kann, dass sich die Temperatur der Elektronikeinrichtung stets unterhalb der Ausfalltemperatur befindet. Das Luftfahrzeugaußenhautwärmetauscher-Bypassventil kann auch geöffnet werden, falls die Temperatur des Luftfahrzeugaußenhautwärmetauschers höher als die Ist-Temperatur des aus dem Kühlwärmetauschers austretenden Kühlmittels ist.

Das Luftfahrzeugaußenhautwärmetauscher-Bypassventil kann dazu ausgebildet sein, das Kühlmittel am Luftfahrzeugaußenhautwärmetauscher zumindest teilweise vorbeizuleiten, falls die Temperatur im Luftfahrzeugaußenhautwärmetauscher und/oder des Kühlmittels je einen entsprechenden zweiten Schwellenwert unterschreitet. Dadurch kann sichergestellt werden, dass sich die Temperatur der die Elektronikeinrichtung umgebenden Luft stets über dem Taupunkt befindet, was die Zuverlässigkeit und Lebensdauer der Elektronikeinrichtung und somit die Sicherheit des Luftfahrzeuges erhöht. Folglich kann der zweite Schwellenwert so ausgewählt werden, dass die die Elektronikeinrichtung umgebende Luft eine Temperatur aufweist, die sich oberhalb des Taupunktes befindet. Es versteht sich, dass anstelle eines Luftfahrzeugaußenhautwärmetauscher-Bypassventils mit zwei Schwellenwerten zwei Luftfahrzeugaußenhautwärmetauscher-Bypassventile vorgesehen sein können, die je auf einen Schwellenwert ansprechen.

Die Luftfahrzeugkühleinrichtung kann ein Pumpeinrichtungs-Bypassventil aufweisen, das dazu ausgebildet ist, das Kühlmittel bei einem Fehler der Pumpeinrichtung an der Pumpeinrichtung vorbeizuleiten. Das Pumpeinrichtungs-Bypassventil kann *parallel* zur Pumpeinrichtung angeschlossen sein. Das Pumpeinrichtungs-Bypassventil kann eine Feder aufweisen, die das Ventil bei einer voreingestellten Druckdifferenz öffnet.

Das Kühlmittel kann so ausgebildet sein, dass es im Fehlerfall im Kühlwärmetauscher bei einer Temperatur oberhalb des Taupunktes der die Elektronikeinrichtung umgebenden Luft verdampft. Die Luftfahrzeugkühleinrichtung kann so ausgebildet sein, dass im Fehlerfall durch das Verdampfen des Kühlmittels im Kühlwärmetauscher die Elektronikeinrichtung eine Temperatur unter der Ausfalltemperatur der Elektronikeinrichtung aufweist.

Die Pumpeinrichtung kann in Flussrichtung des Kühlmittels nach dem Luftfahrzeugaußenhautwärmetauscher und vor dem Zusatzwärmetauscher angeordnet sein. Der Kühlwärmetauscher befindet sich in Flussrichtung des Kühlmittels hinter dem Zusatzwärmetauscher. Es kann ein Reservoir zum Ausgleich einer thermischen Expansion des Kühlmittels und/oder zum Nachfüllen von Kühlmittel im Fall einer Leckage vorhanden sein.

Die Erfindung betrifft auch ein redundantes Luftfahrzeugelektronikkühlsystem, das eine Mehrzahl der zuvor beschriebenen Luftfahrzeugkühleinrichtungen aufweist, wobei die Mehrzahl von Luftfahrzeugkühleinrichtungen zum Kühlen derselben Elektronikeinrichtung ausgebildet sind. Dadurch ergibt sich eine besonders ausfallsichere Kühlung der Elektronikeinrichtung, wodurch die Sicherheit des Luftfahrzeuges nochmals erhöht wird.

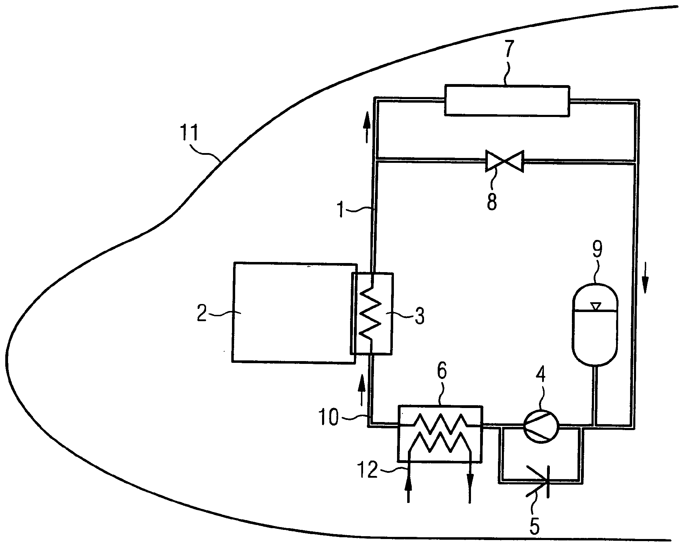

Die Erfindung wird jetzt unter Bezugnahme auf die beigefügte Figur erläutert, die schematisch eine erfindungsgemäße Luftfahrzeugkühleinrichtung zeigt.

Ein Luftfahrzeug 11 weist eine Elektronikeinrichtung 2 auf. Die Elektronikeinrichtung 2 kann sich beispielsweise zusammen mit einer Mehrzahl von Elektronikeinrichtungen 2 in einem Schaltschrank (nicht gezeigt) befinden. Die Elektronikeinrichtung 2 ist mit einem Kühlwärmetauscher 3 thermisch gekoppelt. Diese thermische Kopplung kann mittels eines Gases, einer Flüssigkeit oder einer mechanischen Verbindung erfolgen. Der Kühlwärmetauscher 3 ist an eine Zuführleitung 10 angeschlossen, die dem Kühlwärmetauscher 3 flüssiges Kühlmittel zuführt. Das zugeführte Kühlmittel kühlt aufgrund der zuvor beschriebenen thermischen Kopplung die Elektronikeinrichtung 2. Im Normalbetrieb tritt das Kühlmittel als flüssiges Kühlmittel in die Abgabeleitung 1 ein und wird dem Luftfahrzeugaußenhautwärmetauscher 7 als flüssiges Kühlmittel zugeführt. Dort wird das Kühlmittel gekühlt, indem ihm Wärme entzogen wird, die an die Umgebung des Luftfahrzeuges abgegeben wird. Das aus dem Luftfahrzeugaußenhautwärmetauscher 7 austretende Kühlmittel tritt in eine Pumpeinrichtung 4 ein, die das Kühlmittel über einen Zusatzwärmetauscher 6 und die Zuführleitung 10 wieder dem Kühlwärmetauscher 3 zuführt. Das Kühlmittel durchläuft folglich einen geschlossenen Kreislauf.

Im Normalbetrieb, d.h. bei funktionsfähiger Pumpeinrichtung 4, befindet sich das Kühlmittel ständig in einem geschlossenen Kreislauf. Durch Einstellen der Pumpleistung der Pumpeinrichtung 4 kann die Temperatur des Kühlmittels beim Eintritt in den Kühlwärmetauscher und somit die Temperatur der Elektronikeinrichtung besonders einfach eingestellt werden. Die Temperatur der Elektronikeinrichtung 2 soll vorzugsweise einen solchen Wert aufweisen, dass sich die Temperatur der die Elektronikeinrichtung 2 umgebenden Luft stets über dem Taupunkt befindet. Ferner muss die Temperatur der Elektronikeinrichtung 2 niedriger als die Ausfalltemperatur sein.

Wie zuvor erwähnt wurde, befindet sich in dem Kühlkreislauf ein Zusatzwärmetauscher 6. Falls sich das Luftfahrzeug 11 am Boden befindet, kann die Außentemperatur so hoch sein, dass der Luftfahrzeugaußenhautwärmetauscher 7 dem Kühlmittel keine oder nicht genügend Wärme entziehen kann. In diesem Fall wird das Kühlmittel teilweise oder vollständig im Zusatzwärmetauscher 6 gekühlt und es kann zumindest teilweise nicht durch den Luftfahrzeugaußenhautwärmetauscher 7 strömen. Der Zusatzwärmetauscher 6 kann mittels eines Flüssigkeitskühlsystems, beispielsweise eines sogenannten Kältebusses, oder mittels eines Kühlsystems gekühlt werden, das einen Zyklus aus Verdichtung, Kondensation und Verdampfung aufweist. Eine Zusatzkühlmittelzufuhr 12 erfolgt, falls die Temperatur der Außenluft und/oder die Temperatur des Kühlmittels nach dem Austritt aus dem Luftfahrzeugaußenhautwärmetauscher 7 über einem Schwellenwert liegt. Folglich kann eine Kühlung der Elektronikeinrichtung 2 auch am Boden gewährleistet werden. Bei niedriger Außentemperatur, beispielsweise im Flug, erfolgt die Kühlung des Kühlmittels im Luftfahrzeugaußenhautwärmetauscher 7. In diesem Fall kann die Zusatzkühlmittelzufuhr 12 zum Zusatzwärmetauscher unterbleiben. Es ist auch möglich, parallel zum Zusatzwärmetauscher 6 ein Bypassventil (nicht gezeigt) vorzusehen, das geöffnet wird, falls die Temperatur der Außenluft und/oder die Temperatur des Kühlmittels nach dem Austritt aus dem Luftfahrzeugaußenhautwärmetauscher 7 unter einem Schwellenwert liegt, der sicherstellt, dass das im Kühlkreislauf zirkulierende Kühlmittel die Elektronikeinrichtung 2 ausreichend kühlt. Das Kühlmittel kann sowohl durch den Luftfahrzeugaußenhautwärmetauscher 7 und den Zusatzwärmetauscher 6 strömen, falls der Luftfahrzeugaußenhautwärmetauscher 7 das Kühlmittel nicht auf einen vorbestimmten Sollwert kühlen kann.

Im Kühlkreislauf befindet sich ferner ein Reservoir 9 zum Ausgleich einer Volumenänderung des Kühlmittels und/oder zum Nachfüllen von Kühlmittel im Fall einer Leckage. Das Reservoir 9 befindet sich in der dargestellten Ausführungsform in Flussrichtung des Kühlmittels nach dem Luftfahrzeugaußenhautwärmetauscher 7 und vor dem Zusatzwärmetauscher 6. Das Reservoir 9 kann sich jedoch auch in Flussrichtung des Kühlmittels nach dem Zusatzwärmetauscher 6 und vor dem Kühlwärmetauscher 3 befinden.

Die Pumpeinrichtung 4 befindet sich in der dargestellten Ausführungsform in Strömungsrichtung des Kühlmittels zwischen dem Luftfahrzeugaußenhautwärmetauscher 7 und dem Zusatzwärmetauscher 6. Die Pumpeinrichtung kann sich auch zwischen dem Zusatzwärmetauscher 6 und dem Kühlwärmetauscher 3 befinden. Dem Luftfahrzeugaußenhautwärmetauscher 7 ist zumindest ein Luftfahrzeugaußenhautwärmetauscher-Bypassventil 8 parallel geschaltet. Das Luftfahrzeugaußenhautwärmetauscher-Bypassventil 8 öffnet sich, falls die Außentemperatur so hoch ist, dass das Kühlmittel nicht mehr durch den Luftfahrzeugaußenhautwärmetauscher 7 gekühlt werden kann. Dadurch wird verhindert, dass das Kühlmittel durch den Luftfahrzeugaußenhautwärmetauscher 7 erwärmt wird. Ein Erwärmen des Kühlmittels im Luftfahrzeugaußenhautwärmetauscher 7 ist unerwünscht, da in diesem Fall der Zusatzwärmetauscher 6 mehr Wärme an das Zusatzkühlsystem abführen muss, was den Kerosinverbrauch erhöht.

Das Luftfahrzeugaußenhautwärmetauscher-Bypassventil 8 kann geöffnet sein, falls die Außentemperatur einen Wert unterschreitet, der dazu führt, dass das Kühlmittel soweit abgekühlt wird, dass sich die die Elektronikeinrichtung 2 umgebende Luft unterhalb des Taupunktes befindet. In diesem Fall strömt ein Teil des Kühlmittels durch den Luftfahrzeugaußenhautwärmetauscher 7 und ein anderer Teil durch das Luftfahrzeugaußenhaut-Bypassventil 8. Durch Steuerung der Öffnung oder durch Modulation des Luftfahrzeugaußenhautwärmetauscher-Bypassventils 8 kann die Temperatur des Kühlmittels gesteuert werden, das dem Kühlwärmetauscher 3 zugeführt wird, der mit der Elektronikeinrichtung 2 thermisch gekoppelt ist.

In der dargestellten Ausführungsform kann sich das Luftfahrzeugaußenhautwärmetauscher-Bypassventil 8 bei Überschreiten eines ersten Schwellenwertes, wenn beispielsweise die Außentemperatur zu hoch ist, vollständig öffnen und bei Unterschreiten eines zweiten Schwellenwertes, beispielsweise falls die Außentemperatur zu niedrig ist, zumindest teilweise öffnen oder moduliert werden. Es ist jedoch auch möglich, zwei Luftfahrzeugaußenhautwärmetauscher-Bypassventile vorzusehen, die je auf einen Schwellenwert reagieren. Eine derartige Ausgestaltung wird als äquivalent betrachtet.

Wie zuvor erwähnt wurde, befindet sich das Kühlmittel im Normalbetrieb, beispielsweise bei funktionsfähiger Pumpeinrichtung 4, ständig im flüssigen Zustand. Die Pumpeinrichtung 4 arbeitet lediglich als Pumpe für flüssiges Kühlmittel. Die Pumpeinrichtung 4 arbeitet nicht als Verdichter, und im Normalbetrieb, beispielsweise bei funktionsfähiger Pumpeinrichtung 4 und ausreichender Kühlleistung, tritt keine Kondensation und Verdampfung auf.

Bei einem Ausfall der Pumpeinrichtung 4 erhöht sich die Temperatur des Kühlmittels im Kühlwärmetauscher 3. Dadurch kann das Kühlmittel im Kühlwärmetauscher verdampfen. Das Verdampfen erzeugt einerseits einen Überdruck in Richtung Luftfahrzeugaußenhautwärmetauscher 7 und Pumpeinrichtung 4 und andererseits einen Unterdruck in Richtung Zuführleitung 10 und Zusatzwärmetauscher 6. Dadurch entsteht an der Pumpeinrichtung 4 eine Druckdifferenz. Diese Druckdifferenz bewirkt, dass ein Pumpeinrichtungs-Bypassventil 5 geöffnet wird. Das Pumpeinrichtungs-Bypassventil 5 weist vorzugsweise lediglich mechanische Komponenten auf, wodurch dessen Zuverlässigkeit erhöht wird. Vorzugsweise kann der Auslösedruck des Pumpeinrichtungs-Bypassventils durch eine Feder eingestellt werden.

Diese Ausführungsform ermöglicht auch, dass bei funktionsfähiger Pumpeneinrichtung Kühlmittel an der Pumpeneinrichtung 4 durch das Pumpeneinrichtungs-BypassVentil 5 vorbei strömen kann, falls Kühlmittel beispielsweise wegen einer erhöhten Kühllast im Kühlwärmetauscher 3 verdampft. Auch in diesem Betriebsfall kann das zumindest eine Luftfahrzeugaußenhautwärmetauscher-Bypassventil 8 wie zuvor beschrieben arbeiten.

Bei ausgefallener Pumpeinrichtung 4 verdampft das Kühlmittel 3 im Kühlwärmetauscher und kondensiert im Luftfahrzeugaußenhautwärmetauscher 7. Dazu ist es zweckmäßig, die Abgabeleitung 1 mit einem größeren Querschnitt zu dimensionieren, damit genügend gasförmiges Kühlmittel vom Kühlwärmetauscher 3 zum Luftfahrzeugaußenhautwärmetauscher 7 transportiert werden kann.

Bei Ausfall der Pumpeinrichtung 4 zirkuliert das Kühlmittel aufgrund natürlicher Konvektion durch den Kühlkreislauf. Dadurch kann im Flug eine Kühlung der elektronischen Einrichtung sichergestellt werden, so dass diese weiter betrieben werden kann, was die Zuverlässigkeit und Sicherheit des Luftfahrzeuges erhöht.

Es können zwei oder mehr im Wesentlichen identisch aufgebaute Luftfahrzeugkühleinrichtungen vorgesehen sein, die die selbe Elektronikeinrichtung kühlen. Dadurch entsteht eine zusätzliche Redundanz, was die Zuverlässigkeit und Sicherheit des Luftfahrzeuges weiter erhöht.

Die erfindungsgemäße Luftfahrzeugkühleinrichtung hat den Vorteil, dass durch Verwendung eines flüssigen Kühlmittels der erforderliche Einbauraum reduziert wird. Ferner ist keine Kältemaschine wie im Stand der Technik erforderlich. Im Gegensatz zu einem Kühlsystem mit einem gasförmigen Kühlmittel erfordert die erfindungsgemäße Luftfahrzeugkühleinrichtung keine Ventilatoren und Luftschächte mit einem großen Querschnitt. Dadurch kann die Masse des Kühlsystems und der Stromverbrauch reduziert werden, was den Einbau in ein Luftfahrzeug vereinfacht und den Kerosinbedarf reduziert. Ferner hat das flüssige Kühlmittel den Vorteil, dass die Temperaturunterschiede in der Elektronikeinrichtung verglichen mit einem herkömmlichen gasförmigen Kühlmittel reduziert werden.

Es versteht sich, dass eine Mehrzahl von Luftfahrzeugaußenhautwärmetauscher-Bypassventilen 8, die auf den gleichen Temperaturschwellenwert reagieren, vorgesehen werden kann, um die Zuverlässigkeit des Kühlsystems zu erhöhen. Es ist auch möglich, eine Mehrzahl von Pumpeinrichtungs-Bypassventilen 5 vorzusehen, damit die Zuverlässigkeit der Luftfahrzeugkühleinrichtung erhöht wird. Es ist auch möglich, dass jede zuvor beschriebene Komponente redundant, z.B. durch Parallelschaltung zweier im Wesentlichen identischen Komponenten, ausgelegt wird.

## Patentansprüche

1. Verfahren zum Kühlen einer Elektronikeinrichtung (2) in einem Luftfahrzeug (11), mit den folgenden Schritten:
- Zirkulieren eines Kühlmittels in einem Kühlmittelkreislauf,
- Kühlen der Elektronikeinrichtung (2) mit dem Kühlmittel und
- Abgeben der vom Kühlmittel aufgenommenen Wärme in einem Luftfahrzeugaußenhautwärmetauscher (7),
wobei das Kühlmittel sich im Normalbetrieb ständig in flüssigem Zustand befindet und aufgrund einer Zwangskonvektion im Kühlmittelkreislauf zirkuliert und **dadurch gekennzeichnet, dass** im Fehlerfall und/oder im Fall einer erhöhten Kühlanforderung das Kühlmittel beim Kühlen der Elektronikeinrichtung (2) zumindest teilweise verdampft, im Luftfahrzeugaußenhautwärmetauscher (7) kondensiert und aufgrund natürlicher Konvektion im Kühlmittelkreislauf zirkuliert.

2. Verfahren nach Anspruch 1,
**dadurch gekennzeichnet, dass** das Kühlmittel zumindest teilweise am Luftfahrzeugaußenhautwärmetauscher (7) vorbeigeleitet wird, falls die Temperatur im Luftfahrzeugaußenhautwärmetauscher (7) einen ersten Schwellenwert überschreitet.

3. Verfahren nach Anspruch 1 oder 2,
**dadurch gekennzeichnet, dass** das Kühlmittel fallweise in einem Zusatzwärmetauscher (6) gekühlt wird, der von einem Zusatzkühlsystem gekühlt wird.

4. Verfahren nach einem der Ansprüche 1 bis 3,
**dadurch gekennzeichnet, dass** das Kühlmittel zumindest teilweise am Luftfahrzeugaußenhautwärmetauscher (7) vorbeigeleitet wird, falls die Temperatur im Luftfahrzeugaußenhautwärmetauscher (7) und/oder die Temperatur des Kühlmittels einen zweiten Schwellenwert unterschreitet.

5. Luftfahrzeugkühleinrichtung, mit
- einem Kühlwärmetauscher (3), der dazu ausgebildet ist, mit einem Kühlmittel eine Elektronikeinrichtung (2) zu kühlen, und
- einem Luftfahrzeugaußenhautwärmetauscher (7), der dazu ausgebildet ist, das Kühlmittel zu kühlen, wobei sich der Kühlwärmetauscher (3) und der Luftfahrzeugaußenhautwärmetauscher (7) in einem geschlossenen Kühlmittelkreislauf befinden, und einer Pumpeinrichtung (4), die im Normalbetrieb Kühlmittel im Kühlmittelkreislauf zirkuliert, wobei die Luftfahrzeugkühleinrichtung so ausgebildet und das Kühlmittel so gewählt ist, dass sich im Normalbetrieb das flüssige Kühlmittel ständig in flüssigem Zustand befindet und aufgrund einer Zwangskonvektion durch die Pumpeinrichtung (4) im Kühlmittelkreislauf zirkuliert und **gekennzeichnet dadurch, dass** im Fehlerfall und/oder im Fall einer erhöhten Kühlanforderung das Kühlmittel beim Kühlen der Elektronikeinrichtung (2) zumindest teilweise im Kühlwärmetauscher verdampft, im Luftfahrzeugaußenhautwärmetauscher (7) kondensiert und aufgrund natürlicher Konvektion im Kühlmittelkreislauf zirkuliert.

6. Luftfahrzeugkühleinrichtung nach Anspruch 5,
**gekennzeichnet durch** zumindest ein Luftfahrzeugaußenhautwärmetauscher-Bypassventil (8), das dazu ausgebildet ist, das Kühlmittel am Luftfahrzeugaußenhautwärmetauscher zumindest teilweise vorbeizuleiten, falls die Temperatur im Luftfahrzeugaußenhautwärmetauscher (7) einen ersten Schwellenwert überschreitet.

7. Luftfahrzeugkühleinrichtung nach Anspruch 5 oder 6,
**gekennzeichnet durch** einen Zusatzwärmetauscher (6), der fallweise von einem Zusatzkühlsystem gekühlt wird, wobei der Zusatzwärmetauscher (6) so ausgebildet ist, dass das Kühlmittel des Kühlmittelkreislaufs im Zusatzwärmetauscher (6) gekühlt wird, falls der Zusatzwärmetauscher (6) vom Zusatzkühlsystem gekühlt wird.

8. Luftfahrzeugkühleinrichtung nach einem der Ansprüche 5 bis 7,
**dadurch gekennzeichnet, dass** das zumindest eine Luftfahrzeugaußenhautwärmetauscher-Bypassventil (8) dazu ausgebildet ist, das Kühlmittel am Luftfahrzeugaußenhautwärmetauscher (7) zumindest teilweise vorbeizuleiten, falls die Temperatur im Luftfahrzeugaußenhautwärmetauscher (7) und/oder die Temperatur des Kühlmittels einen zweiten Schwellenwert unterschreitet.

9. Luftfahrzeugkühleinrichtung nach einem der Ansprüche 5 bis 8,
**gekennzeichnet durch** ein Pumpeinrichtungs-Bypassventil (5), das dazu ausgebildet ist, das Kühlmittel bei einem Fehler der Pumpeinrichtung (4) an der Pumpeinrichtung (4) vorbeizuleiten.

10. Luftfahrzeugkühleinrichtung nach einem der Ansprüche 5 bis 9,
**dadurch gekennzeichnet, dass** das Kühlmittel so ausgebildet ist, dass es im Fehlerfall im Kühlwärmetauscher (3) bei einer Temperatur oberhalb des Taupunktes der die Elektronikeinrichtung (2) umgebenden Luft verdampft.

11. Luftfahrzeugkühleinrichtung nach einem der Ansprüche 5 bis 10,
**dadurch gekennzeichnet, dass** die Luftfahrzeugkühleinrichtung so ausgebildet ist, dass im Fehlerfall durch das Verdampfen des Kühlmittels im Kühlwärmetauscher innerhalb der Elektronikeinrichtung eine Temperatur unter der Ausfalltemperatur der Elektronikeinrichtung (2) herrscht.

12. Redundantes Luftfahrzeugelektronikkühlsystem,
**gekennzeichnet durch** eine Mehrzahl von Luftfahrzeugkühleinrichtungen nach einem der Ansprüche 5 bis 11, wobei die Mehrzahl von Luftfahrzeugkühleinrichtungen zum Kühlen der selben Elektronikeinrichtung (2) ausgebildet sind.

## Claims

1. Method for cooling an electronic device (2) in an aircraft (11), comprising the following steps:
- circulating a coolant in a cooling circuit,
- cooling the electronic device (2) by means of the coolant, and,
- in an aircraft outer-shell heat exchanger (7), emitting the heat taken up by the coolant,
wherein, during normal operation, the coolant is permanently in a liquid phase and circulates in the coolant circuit by forced convection **characterized in that**, in the case of a malfunction and/or in the case of an increased cooling demand, the coolant evaporates, at least partially, during the cooling of the electronic device (2), condenses in the aircraft outer-shell heat exchanger (7), and circulates in the coolant circuit by natural convection.

2. Method according to Claim 1,
**characterized in that** the coolant is bypassed past the aircraft outer-shell heat exchanger (7), at least partially, if the temperature in the aircraft outer-shell heat exchanger (7) exceeds a first threshold value.

3. Method according to Claim 1 or 2,
**characterized in that** the coolant is cooled case-by-case in an additional heat exchanger (6), which is cooled by an additional cooling system.

4. Method according to any one of Claims 1 to 3,
**characterized in that** the coolant is bypassed past the aircraft outer-shell heat exchanger (7), at least partially, if the temperature in the aircraft outer-shell heat exchanger (7) and/or the temperature of the coolant falls below a second threshold value.

5. Aircraft cooling device, comprising
- a cooling heat exchanger (3) adapted to cool an electronic device (2) by means of a coolant, and
- an aircraft outer-shell heat exchanger (7) adapted to cool the coolant,
wherein the cooling heat exchanger (3) and the aircraft outer-shell heat exchanger (7) are arranged in a closed coolant circuit, an
- a pump device (4), which, during normal operation, circulates coolant in the coolant circuit, wherein the aircraft cooling device is adapted and the coolant is selected such that, during normal operation, the liquid coolant is permanently in a liquid phase and, because of the pump device (4), circulates in the coolant circuit by forced convection and, **characterized in that**, in the case of a malfunction and/or in the case of an increased cooling demand, the coolant evaporates, at least partially, in the cooling heat exchanger during the cooling of the electronic device (2), condenses in the aircraft outer-shell heat exchanger (7), and circulates in the coolant circuit by natural convection.

6. Aircraft cooling device according to Claim 5,
**characterized by** at least one aircraft outer-shell heat-exchanger bypass valve (8), which is adapted to bypass the coolant past the aircraft outer-shell heat exchanger, at least partially, if the temperature in the aircraft outer-shell heat exchanger (7) exceeds a first threshold value.

7. Aircraft cooling device according to Claim 5 or 6,
**characterized by** an additional heat exchanger (6), which is cooled case-by-case by an additional cooling system, wherein the additional heat exchanger (6) is adapted such that the coolant of the coolant circuit is cooled in the additional heat exchanger (6) if the additional heat exchanger (6) is cooled by the additional cooling system.

8. Aircraft cooling device according to any one of Claims 5 to 7,
**characterized in that** the at least one aircraft outer-shell heat-exchanger bypass valve (8) is adapted to bypass the coolant past the aircraft outer-shell heat exchanger (7), at least partially, if the temperature in the aircraft outer-shell heat exchanger (7) and/or the temperature of the coolant falls below a second threshold value.

9. Aircraft cooling device according to any one of Claims 5 to 8,
**characterized by** a pump-device bypass valve (5), which is adapted to bypass the coolant past the pump device (4) in the case of a malfunction of the pump device (4).

10. Aircraft cooling device according to any one of Claims 5 to 9,
**characterized in that** the coolant is adapted such that, in the case of a malfunction, it evaporates in the cooling heat exchanger (3) at a temperature above the dew point of the air surrounding the electronic device (2).

11. Aircraft cooling device according to any one of Claims 5 to 10,
**characterized in that** the aircraft cooling device is adapted such that, because of the evaporating of the coolant in the cooling heat exchanger, a temperature below the breakdown temperature of the electronic device (2) prevails within the electronic device in the case of a malfunction.

12. Redundant aircraft electronics cooling system,
**characterized by** a plurality of aircraft cooling devices according to any one of Claims 5 to 11, wherein the plurality of aircraft cooling devices is adapted to cool the same electronic device (2).

## Revendications

1. Procédé de refroidissement d'un dispositif électronique (2) à bord d'un aéronef (11), comprenant les étapes suivantes :
- la circulation d'un fluide de refroidissement dans un circuit de refroidissement,
- le refroidissement du dispositif électronique (2) à l'aide du fluide de refroidissement et
- l'évacuation dans un échangeur de chaleur d'enveloppe extérieure d'aéronef (7) de la chaleur absorbée par le fluide de refroidissement,
le fluide de refroidissement se trouvant en permanence à l'état liquide en service normal et circulant par convection forcée dans le circuit de refroidissement, **caractérisé en ce que**
en cas de défaillance et/ou en cas de besoin accru de refroidissement, le fluide de refroidissement est au moins en partie vaporisé lors du refroidissement du dispositif électronique (2), condensé dans l'échangeur de chaleur d'enveloppe extérieure d'aéronef (7) et circule par convection naturelle dans le circuit de refroidissement.

2. Procédé selon la revendication 1,
**caractérisé en ce que** le fluide de refroidissement est conduit au moins en partie le long de l'échangeur de chaleur d'enveloppe extérieure d'aéronef (7) lorsque la température dans l'échangeur de chaleur d'enveloppe extérieure d'aéronef (7) excède une première valeur seuil.

3. Procédé selon la revendication 1 ou 2,
**caractérisé en ce que** le fluide de refroidissement est éventuellement refroidi dans un échangeur de chaleur supplémentaire (6) refroidi par un système de refroidissement supplémentaire.

4. Procédé selon l'une des revendications de 1 à 3,
**caractérisé en ce que** le fluide de refroidissement est conduit au moins en partie le long de l'échangeur de chaleur d'enveloppe extérieure d'aéronef (7) lorsque la température dans l'échangeur de chaleur d'enveloppe extérieure d'aéronef (7) et/ou la température du fluide de refroidissement sont inférieures à une deuxième valeur seuil.

5. Dispositif de refroidissement d'aéronef, comprenant
- un échangeur de chaleur de refroidissement (3) qui est conçu pour refroidir un dispositif électronique (2) à l'aide d'un fluide de refroidissement, et
- un échangeur de chaleur d'enveloppe extérieure d'aéronef (7) qui est conçu pour refroidir le fluide de refroidissement, l'échangeur de chaleur de refroidissement (3) et l'échangeur de chaleur d'enveloppe extérieure d'aéronef (7) se trouvant dans un circuit de refroidissement fermé, et
- un dispositif de pompage (4) qui, en service normal, fait circuler le fluide de refroidissement dans le circuit de refroidissement, le dispositif de refroidissement d'aéronef étant conçu et le fluide de refroidissement choisi pour qu'en service normal, le fluide de refroidissement liquide se trouve en permanence à l'état liquide et circule par convection forcée dans le circuit de refroidissement grâce au dispositif de pompage (4), **caractérisé en ce qu'**en cas de défaillance et/ou en cas de besoin accru de refroidissement, le fluide de refroidissement est au moins en partie vaporisé dans l'échangeur de chaleur de refroidissement lors du refroidissement du dispositif électronique (2), condensé dans l'échangeur de chaleur d'enveloppe extérieure d'aéronef (7) et circule par convection naturelle dans le circuit de refroidissement.

6. Dispositif de refroidissement d'aéronef selon la revendication 5,
**caractérisé par** au moins une valve de dérivation (8) de l'échangeur de chaleur d'enveloppe extérieure d'aéronef, laquelle valve est conçue pour conduire le fluide de refroidissement au moins en partie le long de l'échangeur de chaleur d'enveloppe extérieure d'aéronef (7) lorsque la température dans l'échangeur de chaleur d'enveloppe extérieure d'aéronef (7) excède une première valeur seuil.

7. Dispositif de refroidissement d'aéronef selon la revendication 5 ou 6, **caractérisé par** un échangeur de chaleur supplémentaire (6) qui est éventuellement refroidi par un système de refroidissement supplémentaire, l'échangeur de chaleur supplémentaire (6) étant conçu pour que le fluide de refroidissement du circuit de refroidissement soit refroidi dans l'échangeur de chaleur supplémentaire (6) lorsque l'échangeur de chaleur supplémentaire (6) est refroidi à l'aide d'un système de refroidissement supplémentaire.

8. Dispositif de refroidissement d'aéronef selon l'une des revendications de 5 à 7,
**caractérisé en ce que** ladite au moins une valve de dérivation (8) de l'échangeur de chaleur d'enveloppe extérieure d'aéronef (7) est conçue pour conduire le fluide de refroidissement le long de l'échangeur de chaleur d'enveloppe extérieure d'aéronef (7) lorsque la température dans l'échangeur de chaleur d'enveloppe extérieure d'aéronef (7) et/ou la température du fluide de refroidissement sont inférieures à une deuxième valeur seuil.

9. Dispositif de refroidissement d'aéronef selon l'une des revendications de 5 à 8,
**caractérisé par** une valve de dérivation (5) du dispositif de pompage, laquelle valve est conçue pour conduire le fluide de refroidissement le long du dispositif de pompage (4) en cas de défaillance de celui-ci.

10. Dispositif de refroidissement d'aéronef selon l'une des revendications de 5 à 9,
**caractérisé en ce que** le fluide de refroidissement est conçu pour qu'en cas de défaillance, il se vaporise dans l'échangeur de chaleur de refroidissement (3) à une température supérieure au point de rosée de l'air ambiant entourant le dispositif électronique (2).

11. Dispositif de refroidissement d'aéronef selon l'une des revendications de 5 à 10,
**caractérisé en ce que** le dispositif de refroidissement d'aéronef est conçu pour qu'en cas de défaillance, il règne à l'intérieur du dispositif électronique une température inférieure à la température de défaillance du dispositif électronique (2) grâce à la vaporisation du fluide de refroidissement dans l'échangeur de chaleur de refroidissement.

12. Système de refroidissement électronique d'aéronef redondant,
**caractérisé par** une pluralité de dispositifs de refroidissement d'aéronef selon l'une des revendications 5 à 11, la pluralité de dispositifs de refroidissement d'aéronef étant conçue pour refroidir le même dispositif électronique (2).
